# EUROPÄISCHE PATENTANMELDUNG

(11) **EP 0 827 200 A1**
(43) Veröffentlichungstag der Anmeldung: **04.03.1998**
(21) Anmeldenummer: 97113546.2
(22) Anmeldetag: 06.08.1997
(51) Int. Cl.: H01L 23/552, H05K 1/02, H05K 1/18

(54) **Anordnung zur Abschirmung einer mikroelectronischen Schaltung eines integrierten Schaltkreises**

(30) Priorität: 30.08.1996 DE 19635071
(71) Anmelder: TEMIC TELEFUNKEN microelectronic GmbH, 74072 Heilbronn (DE)
(72) Erfinder: Pollersbeck, Werner, 85104 Pförring (DE)
(74) Vertreter: Maute, Hans-Jürgen, Dipl.-Ing.

(57) **Zusammenfassung**

Anordnung zur Abschirmung einer mikroelektronischen Schaltung (7) eines integrierten Schaltkreises (3), der auf einem Träger (1) und dessen mikroelektronische Schaltung (7) auf einem Substrat (6) angeordnet ist, wobei die mikroelektronische Schaltung (7) auf der dem Träger (1) zugewandten Seite angeordnet ist. Zwischen dem integrierten Schaltkreis (3) und dem Träger (1) ist zusätzlich eine Abschirmleitbahn (9) angeordnet.

## Beschreibung

Die Erfindung betrifft eine Anordnung zur Abschirmung einer mikroelektronischen Schaltung eines integrierten Schaltkreises nach dem Oberbegriff des Patentanspruchs 1.

Elektromagnetische Störungen und die elektromagnetische Verträglichkeit (EMV) werden zunehmend ein Problem. Digitale Schaltkreise, wie Mikroprozessoren, Speicher und Logik-ICs usw., werden einerseits zwecks höherer Leistungsfähigkeit mit immer höheren Taktraten betrieben, wobei das schnellere Schalten gezwungenermaßen steilere Schaltflanken verlangt. Die abgestrahlte (Stör-) Energie in Form elektromagnetischer Strahlung vergrößert sich dabei in Bezug auf die Taktrate in der vierten Potenz.

Andererseits weisen radiowellenbezogene Geräte, wie beispielsweise GPS-(Global Positioning System), Mobilfunk- und Radiogeräte eine immer höhere Empfindlichkeit auf, wodurch sich selbst Störstrahlungen mit kleiner Energie negativ bemerkbar machen.

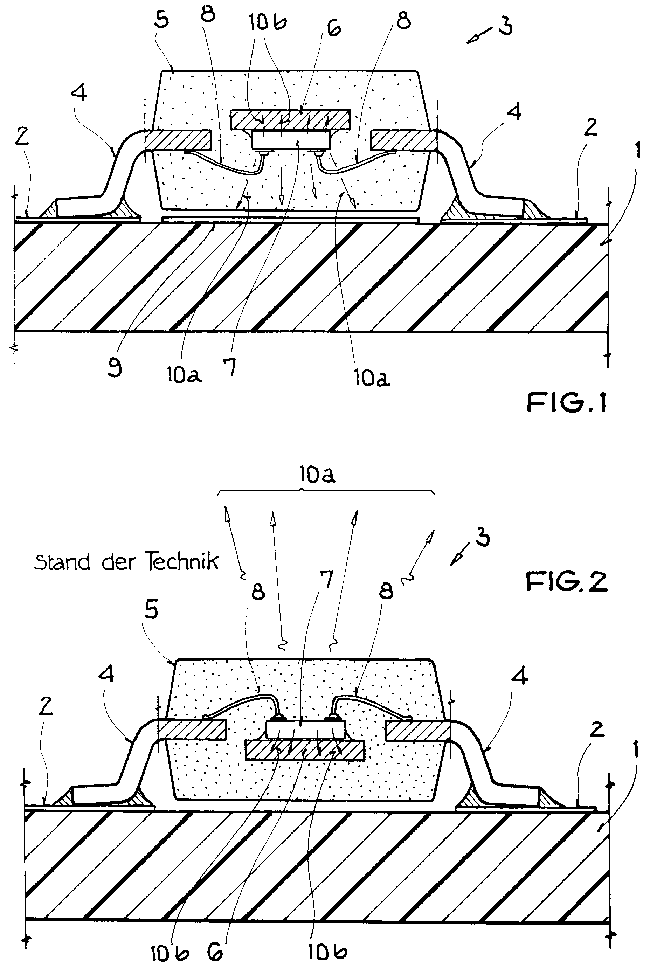

**Fig. 2** zeigt eine Anordnung nach dem Stand der Technik ohne besondere zusätzliche Abschirmvorrichtungen wie Bleche oder dergleichen. Innerhalb eines Integrierten Schaltkreises **3** ist ein Substrat **6** angeordnet und auf dessen Oberseite eine mikroelektronische Schaltung **7**. Beim Betrieb des Integrierten Schaltkreises **3** sendet die mikroelektronische Schaltung **7** hochfrequente elektromagnetische Störstrahlung aus, und zwar hauptsächlich nach oben in Richtung der Pfeile **10a**. Diese hochfrequente elektromagnetische Strahlung, deren Energie in der vierten Potenz zur Taktfrequenz zunimmt, kann in benachbarten Datenleitungen oder mikroelektronischen Schaltungen erhebliche Störungen verursachen und muß deshalb in der Regel abgeschirmt werden. Die in Richtung der Pfeile **10b** abgestrahlte Störenergie wird weitgehend vom Substrat **6**, das in der Regel das Bezugspotential der Schaltung darstellt, absorbiert und verursacht deshalb keine Störungen. Dieser Umstand wird in der vorliegenden Erfindung zur Abschirmung der Störstrahlung angewendet.

Es ist **Stand der Technik**, die mit der Störstrahlung verbundenen Probleme dadurch zu lösen, indem man gesamte Steuergeräte oder Teile davon mit hochfrequenzdichten Gehäusen, Teilabschirmungen oder Massefaltblechen versieht und hochfrequente Störungen in den elektrischen zu- und Ableitungen mittels Kondensatoren und Induktivitäten herausfiltert.

So ist beispielsweise aus der DE-OS 39 15 651 ein Abschirmblech zur Bildung einer Kammer bekannt, die für die Aufnahme von elektrischen, insbesondere gedruckten Schaltung geeignet ist. Hier wird ein komplettes Steuergerät von einer Abschirmkammer umgeben.

Derartige Abschirmmaßnahmen nach dem Stand der Technik weisen den **Nachteil** auf, daß sie zusätzliche Arbeitsschritte und Materialien erfordern oder aber ein merkliches, zusätzliches Gewicht darstellen, beispielsweise bei Verwendung von Metallgehäusen.

Es ist deshalb **Aufgabe der Erfindung**, eine Anordnung anzugeben, bei der die genannten Nachteile vermieden werden.

Diese Aufgabe wird **gelöst** durch eine Anordnung zur Abschirmung einer mikroelektronischen Schaltung eines integrierten Schaltkreises, der auf einem Träger und dessen mikroelektronische Schaltung auf einem Substrat angeordnet ist, wobei die mikroelektronische Schaltung auf der dem Träger zugewandten Seite des Substrates angeordnet ist.

Vorteilhafte Weiterbildungen der Erfindung sind in den Unteransprüchen beschrieben.

Die **Vorteile** der Erfindung liegen darin, daß ohne zusätzliches Gewicht und ohne zusätzliche Arbeitsschritte eine wirksame Abschirmung von elektromagnetischer Störstrahlung erreicht wird.

Ein **Ausführungsbeispiel** der Erfindung ist nachstehend ausführlich erläutert und anhand der Figuren dargestellt.

Es zeigen
- Fig. 1:: eine erfindungsgemäße Anordnung zur Abschirmung von Störstrahlung und
- Fig. 2:: eine Anordnung nach dem Stand der Technik.

Die **Fig. 1** und **2** zeigen eine Anordnung, bestehend aus einem Träger in Form einer Leiterplatte **1** mit Leitbahnen **2**, auf die ein Integrierter Schaltkreis **3** mittels Anschlußbeinchen **4** aufgelötet ist. Der Integrierte Schaltkreis **3** besteht aus einem thermoplastischem Gehäuse **5**, in dem ein Substrat **6** mit einer mikroelektronischen Schaltung **7** angeordnet ist. Leitbahnen **2** und mikroelektronische Schaltung **7** sind mittels Bonddrähten **8**, bestehend aus einer Aluminium- oder Goldlegierung, miteinander verbunden.

Im Gegensatz zum Stand der Technik weist die erfindungsgemäße Anordnung nach **Fig. 1** zwei Besonderheiten auf. So ist zum einen die mikroelektronische Schaltung **7** auf der Unterseite des Substrats **6** und zum anderen unter dem Integrierten Schaltkreis **3** auf der Leiterplatte **1** zusätzlich eine großflächige Abschirmung **9** in Form einer Abschirmleitbahn angeordnet. Beim Betrieb des Integrierten Schaltkreises **3** wird nun die nach oben gemäß den Pfeilen **10b** gerichtete Störstrahlung weitgehend vom Substrat **6** absorbiert und stört somit keine benachbarten Schaltkreise oder Datenleitungen. Die nach unten gemäß den Pfeilen **10a** gerichtete Störstrahlung wird von der Abschirmleitbahn **9** absorbiert und dadurch unschädlich gemacht. Vorzugsweise handelt es sich bei der Abschirmleitbahn **9** um eine auf die Leiterplatte **1** auflaminierte Leitbahn aus Kupfer, deren Breite und Länge den entsprechenden Abmessungen des Integrierten Schaltkreises **3** entsprechen. Wird die Abschirmleitbahn **9** mit dem Bezugspotential, der Versorgungsspannung oder mit einem anderen, geeigneten Potential verbunden, wird die durch die Störstrahlung induzierte Spannung abgeleitet, ohne weitere Störungen verursachen zu können.

Die erfindungsgemäße Anordnung zur Abschirmung hochfrequenter elektromagnetischer Störstrahlung findet ihre Anwendung hauptsächlich bei mikroelektronischen Schaltkreisen, die mit hoher Frequenz getaktet werden, und in deren Nachbarschaft andere störanfällige Schaltkreise oder empfindliche Datenleitungen angeordnet sind. Die Verwendung von Abschirmblechen, metallenen Gehäusen oder anderen Abschirmmaßnahmen erübrigt sich dadurch.

## Patentansprüche

1. Anordnung zur Abschirmung einer mikroelektronischen Schaltung (**7**) eines integrierten Schaltkreises (**3**), der auf einem Träger (**1**) und dessen mikroelektronische Schaltung (**7**) auf einem Substrat (**6**) angeordnet ist, **dadurch gekennzeichnet**, daß die mikroelektronische Schaltung (**7**) auf der dem Träger (**1**) zugewandten Seite des Substrates (**6**) angeordnet ist

2. Anordnung nach Anspruch 1, **dadurch gekennzeichnet**, daß zwischen dem Integrierten Schaltkreis (**3**) und dem Träger (**1**) zusätzlich eine Abschirmung (**9**) angeordnet ist.

3. Anordnung nach Anspruch 2, **dadurch gekennzeichnet**, daß es sich bei der Abschirmung (**9**) um eine auf dem Träger (**1**) angeordnete Abschirmleitbahn handelt.

4. Anordnung nach Anspruch 2 oder 3, **dadurch gekennzeichnet**, daß die Abschirmleitbahn (**9**) mit dem Bezugspotential, der Vorsorgungsspannung oder einem anderen geeigneten Potential der Schaltung (**7**) verbunden ist.

5. Anordnung nach Anspruch 2, 3 oder 4, **dadurch gekennzeichnet**, daß es sich bei der Abschirmleitbahn (**9**) um eine auf den Träger (**1**) auflaminierte Leitbahn aus Kupfer handelt.

6. Anordnung nach Anspruch 1, 2, 3 oder 5, **dadurch gekennzeichnet**, daß es sich bei dem Träger (**1**) um eine Leiterplatte handelt.

7. Anordnung nach Anspruch 3, 4 oder 5, **dadurch gekennzeichnet**, daß die Abschirmleitbahn (**9**) in ihrer Breite und Länge den entsprechenden Abmessungen des Integrierten Schaltkreises (**3**) entspricht.
